# EUROPEAN PATENT APPLICATION

(11) **EP 4 764 622 A1**
(43) Date of publication of application: **24.06.2026**
(21) Application number: 24220636.5
(22) Date of filing: 17.12.2024
(51) Int. Cl.: G02B 1/10, G02B 21/34, G02B 21/33

(54) **LOW SURFACE ENERGY COATED SAMPLE CARRIER FOR IMMERSION-BASED APPLICATIONS**

(71) Applicant: Fraunhofer-Gesellschaft zur Förderung der angewandten Forschung e.V., 80686 München (DE)
(72) Inventor: Rösch, Axel, 37075 Göttingen (DE); Jakobs, Stefan, 37075 Göttingen (DE); Brüsser, Christian, 37075 Göttingen (DE)
(74) Representative: Kuttenkeuler, David

(57) **Abstract**

The invention is based on coating a sample carrier or a lid with a low surface energy coating. It pertains to the coated sample carrier or lid, and to a method of preparing said sample carrier or lid and to their uses. The low-surface energy coating of the invention results in a decreased adherence of immersion fluid to the coated surface of the lid or sample carrier. This makes them particularly useful in immersion-based applications such as immersion microscopy, spectroscopy and/or lithography, in which an immersion objective is in relative motion with the sample carrier or lid.

## Description

### FIELD OF THE INVENTION

The invention is based on coating a sample carrier or a lid with a low surface energy coating. It pertains to the coated sample carrier or lid, and to a method of preparing said sample carrier or lid and to their uses. The low-surface energy coating of the invention results in a decreased adherence of immersion fluid to the coated surface of the lid or sample carrier. This makes them particularly useful in immersion-based applications such as immersion microscopy, spectroscopy and/or lithography, in which an immersion objective is in relative motion with the sample carrier or lid.

### DESCRIPTION

Immersion-based microscopy, lithography and spectroscopy usually requires relative movement of an immersion objective to a sample carrier. These methods rely on an immersion medium that bridges between objective and sample carrier. The immersion media are typically in the shape of a droplet and are based on water, oil and/or silicon-based liquids with a higher refractive index than air. Using such an immersion medium increases numeric aperture and thus is associated with higher spatial resolutions.

During the relative movement of a immersion objective and sample carrier movement, effects such as friction and adhesion between the immersion medium, the objective lens and the sample carrier result in a loss of immersion fluid. This loss is problematic, because it is associated with high costs and can impede data acquisition. A formation of air bubbles can even result in a complete loss of contact between the objective and the sample, which renders subsequently recorded data useless. In particular, high-throughput techniques are impeded by these problems, as the relative movement of immersion objective and sample carrier covers greater overall distances.

A liquid in contact with a solid surface, results in surface wetting, the extent of which is depending on the forces between the liquid and the solid phase. In theory, to avoid surface wetting, the surface energy of a solid surface should be lower than the surface energy of the liquid. The surface energy of a solid is determined by both its chemical composition and surface roughness, herein also referred as microstructuring. Chemical surface coatings with fluoroalkanes, fluorinated polymers, fluorinated surfactants have been developed that provide a surface with the aforementioned low surface energy.

High throughput microscopy measurements are improved by the use of multiwell plate sample carriers. These sample carriers allow a continuous measurement of samples well-by-well without disruption due to the need of sample exchange. However, the base-area of the multiwell plate, that needs to be covered by the immersion fluid increases and requires large amounts of immersion medium to guarantee a homogeneous coverage. Large amounts of immersion fluid are wasted and are required as the immersion fluid often accumulates on the objective, resulting in technical problems and even posing a health hazard for users. In practice, the bottom of a sample plate cannot be covered in immersion fluid fully. Hence, a droplet of oil is carried along while moving the plate under the microscope which due to a loss of fluid limits the time of sample acquisition until new fluid needs to be added, which is a drawback in high-throughput applications.

The loss of immersion fluid is normally compensated by manually adding immersion medium, a laborious task. Alternatively, the lost immersion fluid is replaced by automated dispensers that renew the immersion medium between sample and object carrier. However, these dispensers have only a narrow field of use as they are not a first choice since they tend to encapsulate air bubbles that interfere with the measurement when used with high-viscosity immersion fluids such as oils. Further is immersion fluid generally seen as an environmental hazard which should be reduced as much as possible. Due to these drawbacks, commercially automated microscopes are limited to air or water objectives which are associated with a lower optical resolution than immersion microscopy using oil and/or silicon-based immersion media.

To address the issues related to the loss of immersion fluid in the abovementioned immersion-based applications, the inventors have developed a surface with a low energy surface coating that can be applied to surfaces. By the decrease in surface energy, the adherence of immersion medium to the coated surfaces is decreased. The coating of the invention is therefore useful in immersion based methods or applications, specifically in methods in which immersion medium is moved on a surface, such when moving a sample during immersion microscopy.

Previously, low surface energy surfaces as disclosed herein were thought to be not compatible with the aforementioned optical methods, due to potential optical effects caused by the low surface energy coating or microstructuring of the surface. However, the inventors found that coating a surface as demonstrated herein results in a surface, That does not influence the refractive index of the coated substrate. Surprisingly, the coatings of the invention are highly compatible with optical methods as disclosed herein.

By using the coating of the invention, the amount of immersion fluid that is required can be reduced and samples can be measured or manipulated for an increased time without any disruptions. Dispensers, which are expensive to maintain, are no longer required. Therefore, in case of immersion microscopy, high-numerical oil-based objectives can be used in automated microscopes. For this field, the invention paves the way for establishing high-resolution automated microscopes that rely on oil-objectives.

### BRIEF DESCRIPTION OF THE INVENTION

Generally, and by way of brief description, the main aspects of the present invention can be described as follows:

**In a first aspect,** the invention pertains to a use of a sample carrier in immersion microscopy, spectroscopy or lithography, wherein the sample carrier comprises a substrate with a first surface that comprises a low surface energy coating as a top layer,
and a second surface that does not comprise the low surface energy coating as a top layer,
wherein, the low surface energy coating of the first surface is in contact with an immersion fluid and the second surface faces a sample, and
wherein the low surface energy coating in contact with the immersion fluid while imaging the sample during the immersion microscopy, measuring electromagnetic spectra of the sample during the spectroscopy, or manipulating the sample during the lithography.

**In a second aspect,** the invention pertains to a use of a lid in immersion microscopy, wherein the lid comprises an optically transparent substrate with a first surface that comprises a low surface energy coating as a top layer and a second surface that does not comprise the low surface energy coating as a top layer,

**In a third aspect,** the invention pertains to a use of a surface on a substrate in immersion microscopy, spectroscopy or lithography that comprises a low surface energy coating as a top layer, wherein the low surface energy coating comprises a fluorinated organic compound, wherein the low surface energy coating in contact with an immersion fluid while imaging the sample during the immersion microscopy, measuring electromagnetic spectra of the sample during the spectroscopy, or manipulating the sample during the lithography.

**In a fourth aspect, the invention pertains** to a sample carrier for immersion microscopy, spectroscopy or lithography, wherein the sample carrier comprises a substrate with a first surface that comprises a fluorinated low surface energy coating as a top layer wherein the first surface of the invention does not comprise an additional microstructuring of the substrate and/or wherein the microstructuring of the substrate is not essentially changed by the low energy surface coating.

**In a fifth aspect, the invention pertains to a lid** for immersion microscopy, wherein the lid comprises an optically transparent substrate with a first surface that comprises a fluorinated low surface energy coating as a top layer, wherein the first surface does not comprise an additional microstructuring of the substrate and/or wherein the microstructuring of the substrate is not essentially changed by the low energy surface coating.

**In a sixth aspect,** the invention pertains to a use of a sample carrier or a lid according to any other aspect of the invention in immersion microscopy.

**In a seventh aspect,** the invention pertains to a kit for immersion microscopy, containing a cell culture plate and a lid according to any other aspect of the invention for covering the culture plate.

**In an eighth aspect,** the invention pertains to a kit for immersion microscopy, spectroscopy or lithography, containing an immersion fluid and a sample carrier and/or a lid according to any other aspect of the invention.

**In a ninth aspect,** the invention pertains to a method for preparing a surface of an optically transparent substrate for immersion microscopy, spectroscopy or lithography, the method comprising
(i) Providing a surface on an optically transparent substrate;
(ii) Applying a low surface energy coating as a top layer to the surface on the substrate;
thus obtaining a substrate with a surface that comprises the low surface energy coating as a top layer.

**In a tenth aspect,** the invention pertains to a kit, containing a sample carrier, optionally a lid, and reagents for conducting step (ii) of the method for preparing a surface of a transparent substrate for immersion microscopy, spectroscopy or lithography, and optionally an immersion fluid.

**In an eleventh aspect, the invention pertains to a** method for conducting immersion microscopy, spectroscopy or lithography, the method comprising the steps of:
(a) preparing a first surface of a sample carrier, or lid that comprises an optically transparent substrate according to the method for preparing a surface of an optically transparent substrate for immersion microscopy, spectroscopy or lithography according to the ninth aspect herein,
(b) Using the resulting sample carrier or lid in immersion microscopy according to any other aspect herein.

### DETAILED DESCRIPTION OF THE INVENTION

In the following, the elements of the invention will be described. These elements are listed with specific embodiments, however, it should be understood that they may be combined in any manner and in any number to create additional embodiments. The variously described examples and preferred embodiments should not be construed to limit the present invention to only the explicitly described embodiments. This description should be understood to support and encompass embodiments which combine two or more of the explicitly described embodiments or which combine the one or more of the explicitly described embodiments with any number of the disclosed and/or preferred elements. Furthermore, any permutations and combinations of all described elements in this application should be considered disclosed by the description of the present application unless the context indicates otherwise.

**In a first aspect,** the invention pertains to a use of a sample carrier in immersion microscopy, spectroscopy or lithography, wherein the sample carrier comprises a substrate with a first surface that comprises a low surface energy coating as a top layer,
and a second surface that does not comprise the low surface energy coating as a top layer,
wherein, the low surface energy coating of the first surface is in contact with an immersion fluid and the second surface faces a sample, and
wherein the low surface energy coating in contact with the immersion fluid while imaging the sample during the immersion microscopy, measuring electromagnetic spectra of the sample during the spectroscopy, or manipulating the sample during the lithography.

In the context of the use of the present invention, the immersion microscopy, spectroscopy or lithography refers to a method that is conducted with an immersion objective positioned in the optical path. The term "immersion objective" refers to a lens that is immersed in an immersion fluid.

In the context of the use of the invention, first surface and the second surface are on opposite sides of the sample carrier facing away from each other. In particular preferred embodiments of the invention, the first surface is in contact with an immersion fluid and the second surface is in contact with the sample. This indicates that the immersion fluid is not in contact with the sample. The sample and the immersion fluid are separated by the sample carrier.

In the use of the present invention, the low surface energy coating is in contact with the immersion fluid while imaging the sample during the immersion microscopy, measuring electromagnetic spectra of the sample during the spectroscopy, or manipulating the sample during the lithography. In the method of the invention, the low surface energy coating remains in a low surface energy state while imaging the sample during the immersion microscopy, measuring electromagnetic spectra of the sample during the spectroscopy, or manipulating the sample during the lithography. Preferably, the low surface energy coating remains in a hydrophobic and/or oleophobic state while imaging the sample during the immersion microscopy, measuring electromagnetic spectra of the sample during the spectroscopy, or manipulating the sample during the lithography. In other words, the low surface energy coating is not in a hydrophilic or oleophilic state during the immersion microscopy, measuring electromagnetic spectra of the sample during the spectroscopy, or manipulating the sample during the lithography.

The inventors surprisingly found that the low surface energy coating on the first surface does not significantly change the optical properties of the sample carrier. Therefore, the first surface that comprises the low surface energy interacts essentially the same with light as a non-coated surface. For example, light that would pass through a transparent substrate without the low surface energy coating also passes through a substrate that comprises the low surface energy coating of the invention. This is advantageous for immersion microscopy, spectroscopy and lithography applications that are based on recording electromagnetic waves (therefore light) or manipulating samples with immersion objectives. In these applications, a sample carrier of the invention reduces the overall amount of immersion liquid required, while the image quality is not influenced by the coating.

In preferred embodiments of the invention, the low surface energy coating is not in a hydrophilic state during imaging. While the low surface energy coating of the invention minimizes the wetting of the immersion fluid on the sample carrier, the contact between the immersion objective and the sample carrier by the immersion oil is enough to conduct the immersion microscopy, spectroscopy or lithography of the invention.

In the context of the use of the invention, the term "sample" is to be understood as an object, that is examined or manipulated with the spectroscopy lithography or microscopy of the invention.

If the method of the present invention is an immersion microscopy, then the sample is an object that is imaged using the immersion microscopy. For example, the sample may be a tissue, a cell or a particle.

As already mentioned, a sample carrier as disclosed herein, comprises a low energy surface coating. As this low surface energy coating results in a decreased surface energy, the adhesion of immersion fluid to the first surface of the sample carrier is reduced. This decreases the wetting of the first surface with immersion fluid, results in less immersion fluid that adheres to the first surface and decreases the loss of immersion fluid during immersion-based applications.

As the method of the invention uses a sample carrier of the invention that comprises the low surface energy coating as defined herein, the adherence of immersion medium to the coated surface is decreased. Therefore, when moving the sample during immersion microscopy or spectroscopy and the immersion objective relative to another, the amount of immersion fluid that is required during such a method is reduced. Furthermore, the samples can be measured for an increased time without any disruptions.

In preferred embodiments of the invention, the immersion microscopy is light microscopy, preferably fluorescence microscopy. According to a further embodiment, the microscopy is a super-resolution light microscopy method, in particular a STED microscopy method, a RESOLFT microscopy method, a MINFLUX method, a PALM/STORM method, a SIM method or a SIMFLUX method. In preferred embodiments of the invention, the immersion microscopy is stimulated emission depletion (STED) microscopy. Preferably, the spectroscopy is surface plasmon resonance spectroscopy.

According to a further embodiment, a microscopy of the invention is a confocal (scanning) microscopy method or a wide-field microscopy. Further methods include Fluorescence correlation spectroscopy, Phase Contrast, DIC, and Transmission light, etc. The person of skill is aware of many applications that involve immersion fluids and that would benefit from the herein described invention.

In preferred embodiments of the invention, the lithography is 3D printing. If the method of the present invention is lithography, then the sample is an object that is to be manipulated with lithography. Preferably, such manipulation is an etching or a polymerization. The method of the invention is particularly useful for lithography applications, such as 3D printing applications, as the low surface energy coating results in greater distances that can be traversed by the immersion objective on the first surface before the immersion is lost. Therefore, the area of sample that can be manipulated with the lithography is increased. In preferred embodiments of the invention, the 3D printing is Two-Photon polymerization. A person skilled in the art is capable of perform 3D-printing, such as Two-Photon polymerization such as shown in Bunea et al, Micro 2021, 1(29, 164-180 (DOI: doi.org/10.3390/micro1020013).

The term "surface energy" as used herein refers to an energy that is also known as "interfacial free energy" or "surface free energy". Without wishing to be bound by theory, a material comprises a bulk phase and a surface that forms the interface of said material with its surroundings. In the bulk phase, atoms are generally stable and have a balanced set of bonds/interactions. In contrast, as surface atoms are not surrounded by the bulk of a material, they are under-coordinated. The term "surface energy" refers to the increase of energy at the surface of a material, in comparison to at its bulk due to the disruption of molecular bonds and due to the undercoordination.

Typically, surface energy is determined via contact angle measurements using a contact angle meter. Such experiments rely on measuring the contact angle of a surface with several probe liquids. In general, as surface energy increases, the contact angle of a liquid decreases because more of the liquid is being "grabbed" by the surface. Conversely, as surface energy decreases, the contact angle increases, because the surface doesn't want to interact with the liquid. Based on the contact angle results and knowing the surface tension of the liquids, the surface energy can be calculated. The most common method for calculating the surface energy from the contact angle measurements is the so called "OWRK method" (D. K. Owens, R. C. Wendt: Estimation of the Surface Free Energy of Polymers. In: Journal of Applied Polymer Science. 13, 1969, p. 1743.). In the context of the invention, when referring to surface energy, the surface energy preferably refers to a surface energy as determined by the OWRK method using the probe liquids water and diiodomethane, measured using a Drop Shape Analyzer - DSA100E (KRÜSS GmbH, Germany), wherein the data is evaluated using the software KRÜSS ADVANCE 1.19.0.14201.

In the context of the invention, the term "sample carrier" is meant to be understood as a physical object that, when the sample is subjected to the immersion microscopy, spectroscopy or lithography, is used for positioning of the sample. When the sample is subjected to the immersion microscopy, spectroscopy or lithography, a sample carrier according to the invention acts as a physical barrier that separates the sample from the immersion fluid. In preferred embodiments of the invention, the sample carrier is selected from a culture plate, a microwell plate, a microscope slide, a microfluidic chip, a cover slip, a channeled slide and/or a culture dish. Preferably, the sample carrier, such as the microscope slide or the coverslip is chambered, therefore comprising multiple compartments. Preferably, the sample carrier, such as the microscope slide or the coverslip is channelled.

A microwell-plate refers to a culture plate that is generally known under different interchangeable names such as multiwell plate, reaction plate, microwell plate and microtiter plate. It refers to a sample holder that feature multiple dents that act as reaction chambers, so-called "wells". Microwell plates are known in a variety of different formats such as 6, 12, 24, 48, 96, 384, 1536 and 3456 well plates, indicating the number of reaction chambers. Preferably, volume of an individual well in a microwell plate ranges from 10 mLto 1 µl.

In preferred embodiments of the invention, the sample carrier comprises an optically transparent substrate that comprises the low surface energy coating. The term "optically transparent" indicates that the sample carrier allows the transmission of light waves through the sample carrier. Preferably, the light waves are in the range of about 1 nm to about 1000, more preferably in the range of about 30n nm to about 1000, even more preferably of about 400 nm to about 800 nm. As an example, a use in EUV lithography works in the range of about 13,5 nm. The term optically transparent indicates that the sample carrier preferably is not opaque. In preferred embodiments of the invention, the sample carrier is used in immersion microscopy and is optically transparent.

In preferred embodiments of the invention, the second surface is modified for positioning the sample. Preferably, the second surface comprises a spatial limitation, such as a dent, for example a dent being in the shape of a well, and/or a bump. In preferred embodiments of the invention, the second surface comprises a chemical modification for positioning the sample. Preferably the chemical modification for positioning the sample results in adhesive forces between the sample and the surface. Preferably, the second surface is modified with a reactive group. Preferably, the second surface is modified with a silane-based compound, wherein an alkoxy moiety of the silane-based compound is substituted with a substituent that comprises a reactive group such as a sulfhydryl, ammonium, carbodiimide group. Preferably, the reactive group is a cross-linking moiety, which can optionally be reacted with a bridge reagent. Preferably, the cross-linking moiety is selected from the group consisting of an amino, hydroxyl, carboxyl and sulfhydryl reactive group. Preferably, the bridge reagent is heterobifunctional or homobifunctional. Such a bridge reagent comprises a reactive group that binds with the cross-linking moiety of the second surface. Preferably, the bridge reagent, it further comprises a reactive group for binding a sample. Preferably, the reactive group or the cross-linking moiety is a cleavable group that can be activated for binding of a sample. For example, the cross-linking moiety may be alkylthiol, and the bridge reagent may be cleavable agent with two maleimido moieties. Preferably, the second surface can be modified with lysine, such as poly-L-lysine or poly-D-lysine. Such a poly-D-lysin coating facilitates attachment of cells. Preferably, the second surface is modified with maleimide groups. This enables the binding of sulfhydryl groups via SH moieties. Preferably, the second surface is modified with hydrazide groups. This enables the binding of carbohydrate groups. Preferably, the second surface is modified with an antigen binding moiety. Many surface modifications are known to the skilled artisan and are encompassed by embodiments of the invention. Such coatings may also include coatings with proteinaceous materials such as proteins antibodies, antigens etc, or metals such as gold coatings (useful surface in plasmon resonance), or other chemical or biochemical coatings.In preferred embodiments of the invention, low surface energy coating is a hydrophobic and/or oleophobic coating. Preferably, the hydrophobic coating is a coating that repels water. Preferably, the oleophobic coating is a coating that repels oil. Preferably, the term "hydrophobic coating" indicates that the static water contact angle of the coated surface is θ >90°. Preferably, the term "oleophobic coating" indicates, that the static contact angle of the coated surface with oil is θ >90°. Preferably, the "oil" in this context is hexadecane.

In preferred embodiments of the invention, the low surface energy coating has a surface energy of less than 70 mN/m, preferably less than 30 mN/m, more preferably less than 20 mN/m preferably less than 10 mN/m. Without wishing to be bound by theory, for a surface to be hydrophobic, the surface free energy of the surface must be lower than the surface tension of water, about 72.8 mN/m. Similarly, to be oleophobic, the surface energy of a surface has to be lower than the surface tension of the oil, preferably lower than 20 mN/m, which is a typical surface tension value for oil. Preferably, said surface energy refers to a surface energy, when determined using the probe liquids water and diiodomethane and is measured using a Drop Shape Analyzer - DSA100E (KRÜSS GmbH, Germany), wherein the data is evaluated using the software KRÜSS ADVANCE 1.19.0.14201. In the use of the invention, the first surface is in contact with an immersion fluid. The low surface energy coating of the first surface reduces the amount of immersion fluid that adheres the surface when the immersion fluid is moved on the first surface. The lower the surface energy, the stronger the reduction of immersion fluid that is lost to the surface. Furthermore, with a decreasing surface energy, the amount of immersion fluids that the first surface is "phobic" to, increases.

In preferred embodiments of the invention, the low surface energy coating comprises an organic compound, preferably wherein the organic compound is an organosilicon. In the context of the invention, an "organic compound" is a compound that comprises a chemical bond between a carbon atom and a further atom. Said further atom can be a carbon atom. In the context of the invention, an "organosilicon" is a compound that comprises at least one carbon-silicon bond between an organic residue (also called "organyl" moiety) and a silicon atom of the compound, and/or wherein the compound comprises a carbon atom that is bound via a bridging nitrogen, sulfur, or oxygen atom to a silicon atom of the compound. Silicon carbide is not considered an organosilicon as defined herein. Preferably, term "organosilicon" includes silanes, alkyl silanes and siloxanes.

A "siloxanes" as defined herein refers to a compound that comprises at least two silicon atoms, wherein the at least two silicon atoms are connected via a bridging oxygen atom.

Preferably, the organic compound, preferably the organosilicon, comprises a C₆₋₁₈ alkyl group, a C₆₋₁₈ alkenyl group and/or a C₆₋₁₈ alkynyl group, preferably a C₆₋₁₈ alkyl group. In the context of the invention, the term "alkyl" group preferably refers to an C₆₋₁₈ alkyl group. Surface coatings that contain hydrocarbons (such as a compound comprising a C₆₋₁₈ alkyl group) are known to decrease the surface energy of a surface. Generally, such a hydrocarbon-coated surface is not capable of forming strong bonds with liquids, in particular with water. Therefore, hydrocarbon-coated surfaces are known to be hydrophobic. Preferably, the organic compound is selected from the group consisting of stearic acid and oleic acid. Preferably, the C₆₋₁₈ alkyl group is a linear or branched C₆₋₁₈ alkyl group. Surface coatings that comprise branched hydrocarbon groups are even known to provide the surface of a material with superhydrophobic properties.

In preferred embodiments of the invention, organosilicon is an alkyl silane and/or the organic compound is a fluorinated organic compound. The term "alkyl silane" refers to an organosilicon, wherein the carbon atom of at least one alkyl group, optionally a substituted alkyl group, is directly bound to a silicon atom. Preferably, the at least one, preferably all, hydrogen atoms of the alkyl group is substituted with fluorine. Preferably, the alkyl group is independently selected from a C₆₋₁₈ alkyl group, optionally wherein at least one, preferably all, hydrogen atoms of the independently alkyl group are substituted with fluorine. A fluorinated organic compound, also known as "fluorocarbon", such as polytetrafluorethylene, refers to a compound that comprises at least one chemical bond between a carbon atom and a fluorine atom.

In preferred embodiments of the invention, the low surface energy coating comprises a fluorinated organic compound. Preferably, the fluorinated organic compound is a fluorinated organosilicon. Preferably, the compound comprises fluorinated alkyl groups. In preferred embodiments of the invention, the low surface energy coating comprises a fluorinated siloxane, fluorinated silane, fluorinated organic compound and/or polymers thereof. Without wishing to be bound by theory, fluorinated organic compounds such as fluorinated organosilicons can be coated on a surface, providing the surface with an extreme nonpolar behaviour and an extremely low surface energy. The high electronegativity of fluorine compared with the relatively low electronegativity of carbon results in a dense distribution of electron density away from the centre of mass of each (CF₂) group. In perfluorinated organic compounds, these local dipoles tend to cancel out across a molecule, resulting in no net dipole. Preferably, the fluorinated low surface energy coating comprises a fluorinated organosilicon selected from the group consisting of Trichloro-(1H,1H,2H,2H-perfluoroctyl)-silane, or 1H, 1H, 2H, 2H-perfluorooctyltriethoxysilane. Preferably, the fluorinated low surface energy coating comprises polytetrafluoroethylene. These coatings can strongly reduce surface energy and result in a superhydrophobic and/or oleophobic surface.

In preferred embodiments of the invention, the organic compound, preferably the organosilicon is a polymer. Preferably, the polymer is selected from a halogenated polyolefin and a siloxane. Preferably, the halogenated polyolefin is a fluorinated polyolefin, preferably a perfluorinated polyolefin such as polytetrafluorethylene. Preferably, the siloxane is a polydimethylsiloxane (PDMS) or a derivative thereof.

In preferred embodiments of the invention, the low surface energy coating is a thin film with a thickness of less than 30 nm. In preferred embodiments of the invention, the thin film comprises a thickness of less than 20 nm, less than 15 nm, less than 10 nm, less than 5 nm. In particularly preferred embodiment the low surface energy coating comprises a thickness of less than 2 nm, most preferably of less than 1 nm. By having a coating with such a small thickness, optical effects caused by the surface coating are avoided. With decreasing thickness of the coating, aberrations, for example caused by an altered refractive index, in the optical path are reduced. This is in particular advantageous for high-resolution light microscopy.

In preferred embodiments of the invention, the thin film is a monolayer and/or is bound to the surface via chemisorption and/or physisorption. In particularly preferred embodiments, the coating is a self-assembled monolayer (SAM). A self-assembled monolayer, as used herein, refers to a film comprising a plurality of molecules on a substrate, wherein the molecules are attached via chemisorption to the substrate surface. Preferably, the organic molecules are attached in a single layer on the substrate surface. Preferably, the organic molecules are attached reversibly on the substrate surface. The layer may be considered "self-assembled" because the molecules that form the layer may organize on their own, such as by the bonding of the head groups to the surface and the chemical interaction between neighbouring body groups and tail groups. The organic molecule comprises (i) a head group, by which the organic molecules is attached to the surface of the substrate, (ii) a backbone, and optionally (iii) a terminal group. Suitable head groups, by which the plurality of organic molecule is attached to the surface are readily known to the person skilled in the art. For examples SAMs include n-alkyl silanes on a hydroxylated surface (such as silica, glass, alumina), alkane thiols, and disulfides on metal surfaces (gold, silver, copper), amines and alcohols on platinum, carboxylic acids on aluminum oxide, and silver and phosphates (phosphoric acid or phosphonate groups) on titanium or tantalum surfaces. Preferably, the SAM comprises a tail group that results in a low energy surface.

In preferred embodiments of the invention, the substrate comprises an inorganic glass or crystal (such as quartz), an organic polymer, an organosilicon polymer and/or a metal. In preferred embodiments of the invention, wherein the substrate comprises an inorganic glass or crystal (such as quartz), an organic polymer, an organosilicon polymer and/or a metal. Preferably, the substrate comprises an inorganic glass or crystal (such as quartz), an organic polymer, and/or an organosilicon polymer. Preferably, the polymer is a polypropylene, polystyrene, polycarbonate and/or a polyvinylchloride. Preferably the substrate comprises a metal. Preferably, the metal is Au, Ag, Cu, Al, and/or an alloy thereof. A substrate that comprises a metal is advantageous due to its sensitivity in surface plasmon resonance spectroscopy.

In preferred embodiments of the invention, the first surface does not comprise an additional microstructuring of the substrate. For example, such an additional microstructuring would be an etching of the surface of the substrate, for example to achieve a so-called "Lotus Effect". The surface of the invention that comprises the low energy coating, preferably the first surface as defined herein, comprises a "coating". A coating in this context refers to a surface modification that comprises a layer of chemical compounds on the surface. This coating results in the low surface energy of the low energy surface. Preferably, the low surface energy coating of the invention does not essentially change the microstructuring of the substrate. This is particularly advantageous, as a change in the microstructuring of the substrate can negatively affect the optical properties of the substrate. A surface of the invention that does not comprise an additional microstructuring of the substrate and/or wherein the microstructuring of the substrate is not essentially changed by the low energy surface coating, has essentially the same optical properties as the initial substrate. Therefore, the optical properties of such a substrate can be well-controlled.

In preferred embodiments of the invention, the use is for decreasing the amount of immersion fluid that is necessary for imaging or manipulating an area. As already indicated, the amount of immersion fluid that is required in applications such as immersion microscopy, spectroscopy or lithography is minimized when conducting a method of the invention, because the immersion fluid does not adhere to the surface of the sample carrier of the invention.

**In a second aspect,** the invention pertains to a use of a lid in immersion microscopy, wherein the lid comprises an optically transparent substrate with a first surface that comprises a low surface energy coating as a top layer and a second surface that does not comprise the low surface energy coating as a top layer,
the first surface and the second surface are on opposite sides of the substrate facing away from each other, and
wherein the first surface is in contact with an immersion fluid, and the second surface faces the sample,
wherein the low surface energy coating in contact with the immersion fluid while imaging the sample during the immersion microscopy.

In preferred embodiments of the second aspect, the low surface energy coating is a low surface energy coating according to the first aspect of the invention. Preferably, the low surface energy coating is a fluorinated low surface energy coating. Preferably, the fluorinated low surface energy coating comprises a fluorinated organosilicon selected from the group consisting of Trichloro-(1H,1H,2H,2H-perfluoroctyl)-silane, or 1H, 1H, 2H, 2H-perfluorooctyltriethoxysilane. Preferably, the fluorinated low surface energy coating comprises polytetrafluoroethylene. These coatings can strongly reduce surface energy and result in a superhydrophobic and/or oleophobic surface.

In preferred embodiments of the invention, the substrate is a substrate according to the first aspect of the invention. In preferred embodiments of the invention, the sample is a sample according to the first aspect of the invention. In preferred embodiments of the invention, the immersion microscopy is an immersion microscopy according to the first aspect of the invention. Preferably, the low surface energy coating, the substrate, the sample and the immersion microscopy are as defined according to the first aspect of the invention. In preferred embodiments of the second aspect, the first surface a first surface according to the first aspect of the invention.

Preferably, the lid is used together with the substrate carrier of the first aspect of the invention. In preferred embodiments of the second aspect, the lid or cover slip is a lid for covering a culture plate.

**In a third aspect,** the invention pertains to a use of a surface on a substrate in immersion microscopy, spectroscopy or lithography that comprises a low surface energy coating as a top layer, wherein the low surface energy coating comprises a fluorinated organic compound, wherein the low surface energy coating in contact with an immersion fluid while imaging the sample during the immersion microscopy, measuring electromagnetic spectra of the sample during the spectroscopy, or manipulating the sample during the lithography.

In preferred embodiments of the invention, the immersion microscopy, spectroscopy or lithography is defined as in the first or second aspect of the invention.

In preferred embodiments of this aspect, the surface is on an optically transparent substrate. In preferred embodiments of this aspect, the surface is on an optically transparent substrate and the use is in immersion microscopy. Preferably, the immersion microscopy disclosed herein above, or is preferably STED microscopy.

In preferred embodiments of the third aspect of the invention, the surface that comprises the low surface energy coating preferably faces the sample and/or is in contact with the sample. In preferred embodiments of the third aspect of the invention, the surface that comprises the low surface energy coating preferably faces away from the sample.

In the third aspect of the invention, the surface is in contact with the immersion fluid. As the coating of the invention is a low surface energy coating, preferably a hydrophobic and/or an oleophobic coating, the amount of immersion fluid that is attached to the surface that comprises the coating of the invention is minimized. Therefore, in applications that rely on moving a droplet of immersion fluid droplet on the surface, the amount of immersion fluid required is reduced.

In preferred embodiments of the invention, the substrate is a substrate according to the first aspect of the invention. In preferred embodiments of the invention, the low surface energy coating is a low surface energy coating according to the first aspect of the invention that comprises a fluorinated organic compound. In preferred embodiments of the invention, the low surface energy coating has a surface energy as defined in the first aspect of the invention, preferably of less than 20 mN/m.

In preferred embodiments of the third aspect, the low surface energy coating is a thin film comprising a thickness of less than 30 nm, preferably as determined by spectroscopic ellipsometry. Preferably, low surface energy coating is a thin film comprising a thickness as defined in the first aspect of the invention. In preferred embodiments of the third aspect, the thin film is a monolayer and/or is bound to the surface via chemisorption and/or physisorption. In preferred embodiment of the third aspect, the thin film is a SAM as defined in the context of the first aspect of the invention.

In preferred embodiments of the third aspect, the fluorinated organic compound is a fluorinated organic compound as defined in the first aspect of the invention. Therefore, preferably, the fluorinated organic compound is a fluorinated organosilicon. Preferably, the fluorinated organic compound comprises fluorinated alkyl groups. In preferred embodiments of the invention, the low surface energy coating comprises a fluorinated siloxane, fluorinated silane, fluorinated organic compound and/or polymers thereof.

In preferred embodiments of the third aspect, the fluorinated organosilicon is an fluorinated alkyl silane, wherein the at least one, preferably all, hydrogen atoms of the alkyl group is substituted with fluorine. Preferably, the alkyl group is independently selected from a C₆₋₁₈ alkyl group, wherein at least one, preferably all, hydrogen atoms of the independently selected alkyl group is substituted with fluorine. A fluorinated organic compound, also known as "fluorocarbon", such as polytetrafluorethylene, refers to a compound that comprises at least one chemical bond between a carbon atom and a fluorine atom.

In preferred embodiments of the third aspect, the fluorinated organic compound, preferably the fluorinated organosilicon, is a polymer. Preferably, the polymer is selected from a fluorinated polyolefin. Preferably, the fluorinated polyolefin is a perfluorinated polyolefin, preferably a polytetrafluorethylene.

Preferably, the low surface energy coating is a low surface energy coating as defined according to the first aspect of the invention.

In preferred embodiments of the invention, the surface is a surface as defined in the first aspect of the invention. In preferred embodiment of the invention surface, the surface, as defined in the first aspect of the invention, does not comprise an additional microstructuring of the substrate and/or wherein the low surface energy coating does not essentially change the microstructuring of the substrate.

**In a fourth aspect, the invention pertains** to a sample carrier for immersion microscopy, spectroscopy or lithography, wherein the sample carrier comprises a substrate with a first surface that comprises a fluorinated low surface energy coating as a top layer wherein the first surface of the invention does not comprise an additional microstructuring of the substrate and/or wherein the microstructuring of the substrate is not essentially changed by the low energy surface coating.

In preferred embodiment of the invention, the sample carrier is for immersion microscopy and the substrate is an optically transparent substrate.

In preferred embodiments of the invention, the immersion microscopy, spectroscopy or lithography is defined as in any other aspect of the invention.

In preferred embodiment of the invention, the sample carrier of the fourth aspect of the invention comprises a second surface that does not comprise the low surface energy coating. In preferred embodiment of the invention, wherein the second surface is modified for positioning the sample. Preferably said second surface is as surface as defined in the context of the first or second aspect of the invention.

In preferred embodiments of the invention, wherein the first surface and the second surface are on opposite sides of the substrate facing away from each other.

In preferred embodiment of the invention, the sample carrier is a sample carrier according to any other aspect of the invention. In preferred embodiment of the invention, the sample carrier is a sample carrier according to the first aspect of the invention. Preferably, the sample carrier is a culture plate, a microwell plate, a microscope slide, a microfluidic chip, a cover slip, a channelled slide and/or a culture dish.

**In a fifth aspect, the invention pertains to a lid** for immersion microscopy, wherein the lid comprises an optically transparent substrate with a first surface that comprises a fluorinated low surface energy coating as a top layer, wherein the first surface does not comprise an additional microstructuring of the substrate and/or wherein the microstructuring of the substrate is not essentially changed by the low energy surface coating.

In preferred embodiments of the invention, the lid for immersion microscopy is a lid as defined according to the second aspect of the invention. Preferably, the lid is a lid for covering a culture plate.

In preferred embodiments of the invention, the lid comprises a second surface that does not comprise the low surface energy coating.

In preferred embodiments of the lid according to the fifth aspect of the invention, the first surface and the second surface are on opposite sides of the substrate facing away from each other.

Preferably, the fluorinated low surface energy coating of the fourth and fifth aspect of the invention is a fluorinated low surface energy coating according to any other aspect of the invention. In preferred embodiments of the invention, the fluorinated low surface energy coating is a thin film with a thickness of less than 30 nm, preferably as determined by spectroscopic ellipsometry. Preferably, the fluorinated low surface energy coating has a surface energy of less than 70 mN/m, preferably less than 30 mN/m, more preferably less than 20 mN/m, preferably less than 10 mN/m. In preferred embodiments of the invention, the fluorinated low surface energy coating is a hydrophobic and/or oleophobic coating. In preferred embodiments of the invention, the fluorinated low surface energy coating comprises a fluorinated organic compound, preferably, wherein the fluorinated organic compound is a fluorinated organosilicon. Preferably, the fluorinated organosilicon is a fluorinated alkyl silane. In preferred embodiments of the invention, the fluorinated organic compound, preferably the fluorinated organosilicon, is a polymer. Preferably, the fluorinated low surface energy coating comprises fluorinated alkyl groups. In preferred embodiments of the invention of the fourth or fifth aspect, wherein the low surface energy coating comprises a fluorinated siloxane, fluorinated silane, fluorinated organic compound and/or polymers thereof. Preferably, the fluorinated low surface energy coating comprises a fluorinated organosilicon selected from the group consisting of Trichloro-(1H,1H,2H,2H-perfluoroctyl)-silane, or 1H, 1H, 2H, 2H-perfluorooctyltriethoxysilane. Preferably, the fluorinated low surface energy coating comprises polytetrafluoroethylene. These coatings can strongly reduce surface energy and result in a superhydrophobic and/or oleophobic surface.

In preferred embodiments of the fourth or fifth aspect of the invention, the first surface is a first surface as defined in the first aspect of the invention. In preferred embodiments of the fourth or fifth aspect of the invention, the first surface, as defined in the first aspect of the invention, does not comprise an additional microstructuring of the substrate and/or wherein the low surface energy coating does not essentially change the microstructuring of the substrate. Preferably, the substrate fourth of fifth aspect of the invention is a substrate as defined in any other aspect herein.

**In a sixth aspect,** the invention pertains to a use of a sample carrier or a lid according to any other aspect of the invention in immersion microscopy.

**In a seventh aspect,** the invention pertains to a kit for immersion microscopy, containing a cell culture plate and a lid according to any other aspect of the invention for covering the culture plate.

**In an eighth aspect,** the invention pertains to a kit for immersion microscopy, spectroscopy or lithography, containing an immersion fluid and a sample carrier and/or a lid according to any other aspect of the invention.

In any embodiments of the invention, the immersion fluid, when measured in a sessile drop measurement using a contact angle goniometer, comprises a contact angle of >90°, >100 °, > 120°, > 150° on the first surface. The contact angle of a liquid on a surface depends on the surface energy of the surface and the surface tension of the liquid. The higher the contact angle, the lower is the adherence of a liquid to the surface. With the kit of the eight aspect, the inventors provide a pairing of a sample carrier and/or a lid with an immersion fluid, that is particularly suitable for immersion based applications as defined herein. For example, with increasing duration of a high-throughput measurement and increasing relative distance that a sample carrier and/or lid and the immersion objective in such immersion-based application moves, it is advantageous to have a pairing with a larger contact angle.

In contact angle experiments, the inventors determined a contact angle of above 100° for microscope slide with a surface that comprises the low surface energy coating of the invention using the Immersion Oil Epredia Resolve. On the other hand, a microscope slide that did not comprise the low surface energy coating of the invention, said oil comprised a contact angle of around 50 °. For example, for the invention the use of any known immersion oils is generally possible. Preferred immersion oils are oils with a refractive index of about 1.5181 +/- 0.0004 at 546.1nm and a Abbe Number 44+/-5 at 23°C". Immersion oils according to DIN 58-884" could be applied in the context of the invention.

**In a ninth aspect,** the invention pertains to a method for preparing a surface of an optically transparent substrate for immersion microscopy, spectroscopy or lithography, the method comprising
(iii) Providing a surface on an optically transparent substrate;
(iv) Applying a low surface energy coating as a top layer to the surface on the substrate;
thus obtaining a substrate with a surface that comprises the low surface energy coating as a top layer.

In preferred embodiments of the invention, the substrate is transparent and the substrate is optionally prepared for immersion microscopy. Preferably, the substrate is a substrate as defined in any aspect herein.

Preferably, the low surface energy coating is a low surface energy coating as defined in any aspect herein. Preferably, the low surface energy coating is a fluorinated low surface energy coating. Preferably, the fluorinated low surface energy coating comprises a fluorinated organosilicon selected from the group consisting of Trichloro-(1H,1H,2H,2H-perfluoroctyl)-silane, or 1H, 1H, 2H, 2H-perfluorooctyltriethoxysilane. Preferably, the fluorinated low surface energy coating comprises polytetrafluoroethylene. These coatings can strongly reduce surface energy and result in a superhydrophobic and/or oleophobic surface.

In preferred embodiments of the invention, the method step (i) comprises a step of activating the surface, for example by treatment with plasma, such as air plasma or oxygen plasma, preferably by corona discharge (single electron discharge), arc discharger and air- CO2 plasma, or electric arc discharge.

In preferred embodiments of the invention, the method, step (ii) comprises a step of treating the surface with an organic compound, preferably an organosilicon, as defined in any other aspect herein, or with a precursor thereof.

In preferred embodiments of the invention, wherein in the method step (ii), the organosilicon and/or organic compound is applied in from gas phase or in liquid form, preferably from a solvent, or is printed onto the surface.

Preferably, the surface is a first surface as defined in any aspect herein. Preferably, the surface is a surface of a sample carrier or a lid as defined in any aspect herein.

**In a tenth aspect,** the invention pertains to a kit, containing a sample carrier, optionally a lid, and reagents for conducting step (ii) of the method for preparing a surface of a transparent substrate for immersion microscopy, spectroscopy or lithography, and optionally an immersion fluid.

**In an eleventh aspect, the invention pertains to a** method for conducting immersion microscopy, spectroscopy or lithography, the method comprising the steps of:
(c) preparing a first surface of a sample carrier, or lid that comprises an optically transparent substrate according to the method for preparing a surface of an optically transparent substrate for immersion microscopy, spectroscopy or lithography according to the ninth aspect herein,
(d) Using the resulting sample carrier or lid in immersion microscopy according to any other aspect herein.

Preferably, the method is a method of conducting immersion microscopy and the substrate is an optically transparent substrate.

In further preferred embodiments, the invention pertains to the following itemized embodiments:
Item 1: A use of a sample carrier in immersion microscopy, spectroscopy or lithography, wherein the sample carrier comprises a substrate with a first surface that comprises a low surface energy coating as a top layer,
   and a second surface that does not comprise the low surface energy coating as a top layer,
   wherein, the low surface energy coating of the first surface is in contact with an immersion fluid and the second surface faces a sample, and
   wherein the low surface energy coating in contact with the immersion fluid while imaging the sample during the immersion microscopy, measuring electromagnetic spectra of the sample during the spectroscopy, or manipulating the sample during the lithography.
Item 2: The use of item 1, wherein the sample carrier comprises an optically transparent substrate that comprises the low surface energy coating.
Item 3: The use of item 1 or 2, wherein the low surface energy coating is a thin film with a thickness of less than 30 nm, preferably wherein the thin film comprises a thickness of less than 20 nm, less than 15 nm, less than 10 nm, less than 5 nm, preferably as determined by spectroscopic ellipsometry.
Item 4: The use of any one of items 1 to 3, wherein the sample carrier is used in immersion microscopy and is optically transparent.
Item 5: The use of any one of items 1 to 4, wherein the sample carrier is a culture plate, a microwell plate, a microscope slide, a microfluidic chip, a cover slip, a channelled slide and/or a culture dish.
Item 6: The use of any one of items 1 to 5, wherein the second surface is modified for positioning the sample.
Item 7: The use of the sample carrier of any one of items 1 to 6, wherein the low surface energy coating is a hydrophobic and/or oleophobic coating.
Item 8: The use of the sample carrier of any one of items 1 to 7, wherein the low surface energy coating has a surface energy of less than 70 mN/m, preferably less than 30 mN/m, more preferably less than 20 mN/m preferably less than 10 mN/m.
Item 9: The use of the sample carrier of any one of items 1 to 8, wherein the low surface energy coating comprises an organic compound, preferably, wherein the organic compound is an organosilicon.
Item 10: The use of the sample carrier of any one of any one of items 1 to 9, wherein the low surface energy coating comprises a fluorinated organic compound, preferably wherein the fluorinated organic compound is a fluorinated organosilicon.
Item 11: The use of the sample carrier of any one of item 9 or 10, wherein the organosilicon is an alkyl silane and/or the organic compound is a fluorinated organic compound.
Item 12: The use of the sample carrier of any one of items 9 to 11, wherein the organic compound, preferably the organosilicon, is a polymer.
Item 13: The use of the sample carrier of any one of items 1 to 12, wherein the low surface energy coating comprises a fluorinated siloxane, fluorinated silane, fluorinated organic compound and/or polymers thereof.
Item 14: The use of the sample carrier of any one of items 1 to 13, wherein the thin film is a monolayer and/or is bound to the surface via chemisorption and/or physisorption.
Item 15: The use of the sample carrier of any one of items 1 to 14, wherein the substrate comprises an inorganic glass or crystal (such as quartz), an organic polymer, an organosilicon polymer and/or a metal.
Item 16: The use of the sample carrier of any one of items 1 to 15, wherein the first surface does not comprise an additional microstructuring of the substrate and/or wherein the low surface energy coating does not essentially change the microstructuring of the substrate.
Item 17: The use sample carrier of any one of items 1 to 16, wherein the immersion microscopy is light microscopy, preferably fluorescence microscopy.
Item 18: The use of the sample carrier of any one of item 1 to 17, wherein the immersion microscopy is STED microscopy, a RESOLFT microscopy method, a MINFLUX method, a PALM/STORM method, a SIM method or a SIMFLUX method.
Item 19: A use of a lid in immersion microscopy, wherein the lid comprises an optically transparent substrate with a first surface that comprises a low surface energy coating as a top layer and a second surface that does not comprise the low surface energy coating as a top layer,
   the first surface and the second surface are on opposite sides of the substrate facing away from each other, and
   wherein the first surface is in contact with an immersion fluid, and the second surface faces the sample,
   wherein the low surface energy coating in contact with an immersion fluid while imaging the sample during the immersion microscopy.
Item 20: The use of the lid of item 19, wherein the lid is a lid for covering a culture plate.
Item 21: The use of the lid of item 19 or 20, wherein the coating is a thin film with a thickness of less than 30 nm, preferably as determined by spectroscopic ellipsometry.
Item 22: Use a surface on a substrate in immersion microscopy, spectroscopy or lithography that comprises a low surface energy coating as a top layer, wherein the low surface energy coating comprises a fluorinated organic compound, wherein the low surface energy coating in contact with an immersion fluid while imaging the sample during the immersion microscopy, measuring electromagnetic spectra of the sample during the spectroscopy, or manipulating the sample during the lithography.
Item 23: The use of the surface of item 22, wherein the surface does not comprise an additional microstructuring of the substrate and/or wherein the low surface energy coating essentially does not change the microstructuring of the substrate.
Item 24: The use of the surface of item 22 or 23, wherein the immersion microcopy is a STED microscopy method, a RESOLFT microscopy method, a MINFLUX method, a PALM/STORM method, a SIM method or a SIMFLUX method.
**Item 25: A sample carrier for immersion** microscopy, spectroscopy or lithography, wherein the sample carrier comprises a substrate with a first surface that comprises a fluorinated low surface energy coating as a top layer, wherein the first surface does not comprise an additional microstructuring of the substrate and/or wherein the microstructuring of the substrate is not essentially changed by the low energy surface coating.
Item 26: The sample carrier of item 25, wherein the sample carrier is for immersion microscopy and the sample carrier comprises an optically transparent substrate.
Item 27: The sample carrier of item 25 or 26, wherein the sample carrier comprises a second surface that does not comprise the low surface energy coating
Item 28: The sample carrier of item 25 to 27, wherein the second surface is modified for positioning the sample.
Item 29: The sample carrier of any one of items 25 to 28, wherein the first surface and the second surface are on opposite sides of the substrate facing away from each other.
Item 30: The sample carrier of any one of items 25 to 29, wherein the sample carrier is a culture plate, a microwell plate, a microscope slide, a microfluidic chip, a cover slip, a channelled slide and/or a culture dish.
**Item 31: A lid for immersion microscopy,** wherein the lid comprises an optically transparent substrate with a first surface that comprises a fluorinated low surface energy coating as a top layer, wherein the first surface does not comprise an additional microstructuring of the substrate and/or wherein the microstructuring of the substrate is not essentially changed by the low energy surface coating.
Item 32: The lid for immersion microscopy of item 31, wherein the lid comprises a second surface that does not comprise the low surface energy coating.
Item 33: The lid for immersion microscopy of item 31 or 32, wherein the first surface and the second surface are on opposite sides of the substrate facing away from each other.
Item 34: The lid for immersion microscopy of any one of items 31 to 33, wherein the lid is a lid for covering a culture plate.
Item 35: The sample carrier or the lid of any one of items 25 to 34, wherein the low surface energy coating is a thin film with a thickness of less than 30 nm, preferably as determined by spectroscopic ellipsometry.
Item 36: The sample carrier or the lid of any one of items 25 to 34, wherein the fluorinated low surface energy coating is a hydrophobic and/or oleophobic coating.
Item 37: The sample carrier, or the lid of any one of items 25 to 36, wherein the fluorinated low surface energy coating has a surface energy of less than 70 mN/m, preferably less than 30 mN/m, more preferably less than 20 mN/m, preferably less than 10 mN/m.
Item 38: The sample carrier or the lid of any one of items 25 to 37, wherein the fluorinated low surface energy coating comprises a fluorinated organic compound, preferably, wherein the fluorinated organic compound is a fluorinated organosilicon.
Item 39: The sample carrier or the lid of item 38, wherein the fluorinated organosilicon is a fluorinated alkyl silane.
Item 40: The sample carrier or the lid of item 38 or 39, wherein the fluorinated organic compound, preferably the fluorinated organosilicon, is a polymer.
Item 41: The sample carrier or the lid of any one of items 25 to 40, wherein the fluorinated low surface energy coating comprises fluorinated alkyl groups.
Item 42: The sample carrier or the lid of any one of items 24 to 41, wherein the low surface energy coating comprises a fluorinated siloxane, fluorinated silane, fluorinated organic compound and/or polymers thereof.
Item 43: The sample carrier or the lid of any one of items 25 to 42, wherein the first surface does not comprise an additional microstructuring and/or does not essentially change the microstructuring of the substrate.
Item 44: Use of a sample carrier or a lid according to items 25 to 43 in immersion microscopy.
Item 45: A kit for immersion microscopy, containing a cell culture plate and a lid according to any one of items 32 to 44 for covering the culture plate.
Item 46: A kit for immersion microscopy, spectroscopy or lithography, containing an immersion fluid and a sample carrier and/or a lid according to any one of items 1 to 21 or 25 to 45.
Item 47: The kit according to item 46, wherein the immersion fluid, when measured in a sessile drop measurement using a contact angle goniometer, comprises a contact angle of >90°, >100°, > 120°, > 150° on the first surface.
Item 48: The kit according to item 47, wherein the immersion fluid is an immersion oil, preferably a mineral immersion oil, silicone immersion oil and/or halogenated immersion oil, the immersion oil has a kinematic viscosity of that is lower than 1500 mm² s⁻¹ at 37 °C, more preferably lower than 1000 mm² s⁻¹ at 37 °C, more preferably lower than 700 mm²·s⁻¹ at 37 °C, most preferably lower than at least 500 mm²·s⁻¹ at 37 °C, when measured in a Ostwald viscometer at 37 °C.
Item 49: A method for preparing a surface of an optically transparent substrate for immersion microscopy, spectroscopy or lithography, the method comprising
   (i) Providing a surface on an optically transparent substrate;
   (ii) Applying a low surface energy coating as a top layer to the surface on the substrate;
   thus obtaining a substrate with a surface that comprises the low surface energy coating as a top layer.
Item 50: The method of item 49, wherein the substrate is optically transparent and optionally substrate is prepared for immersion microscopy.
Item 51: The method of item 49 or 50, wherein the method step (i) comprises a step of activating the surface, for example by treatment with plasma, such as air plasma or oxygen plasma.
Item 52: The method of any one of items 49 to 50, wherein step (ii) comprises a step of treating the surface with an organic compound, preferably an organosilicon, according to any of the items 9 to 16 or a precursor thereof.
Item 53: The method of item 52, wherein in step (ii) the organosilicon and/or organic compound is applied in from gas phase or in liquid form, preferably from a solvent, or is printed onto the surface.
Item 54: A kit, containing a sample carrier, optionally a lid, and reagents for conducting step (ii) of the method of any one of items 49 to 53, and optionally an immersion fluid.
Item 55: A method for immersion microscopy, spectroscopy or lithography, the method comprising the steps of:
   (a) preparing a first surface of a sample carrier or lid that comprises an optically transparent substrate according to the method of any one of items 49 to 53,
   (b) Using the resulting sample carrier or lid in immersion microscopy, spectroscopy or lithography according to any one of items 1 to 24 and 44.

The terms "of the [present] invention", "in accordance with the invention", "according to the invention" and the like, as used herein are intended to refer to all aspects and embodiments of the invention described and/or claimed herein.

As used herein, the term "comprising" is to be construed as encompassing both "including" and "consisting of", both meanings being specifically intended, and hence individually disclosed embodiments in accordance with the present invention. Where used herein, "and/or" is to be taken as specific disclosure of each of the two specified features or components with or without the other. For example, "A and/or B" is to be taken as specific disclosure of each of (i) A, (ii) B and (iii) A and B, just as if each is set out individually herein. In the context of the present invention, the terms "about" and "approximately" denote an interval of accuracy that the person skilled in the art will understand to still ensure the technical effect of the feature in question. The term typically indicates deviation from the indicated numerical value by ±20%, ±15%, ±10%, and for example ±5%. As will be appreciated by the person of ordinary skill, the specific such deviation for a numerical value for a given technical effect will depend on the nature of the technical effect. For example, a natural or biological technical effect may generally have a larger such deviation than one for a man-made or engineering technical effect. As will be appreciated by the person of ordinary skill, the specific such deviation for a numerical value for a given technical effect will depend on the nature of the technical effect. For example, a natural or biological technical effect may generally have a larger such deviation than one for a man-made or engineering technical effect. Where an indefinite or definite article is used when referring to a singular noun, e.g. "a", "an" or "the", this includes a plural of that noun unless something else is specifically stated.

It is to be understood that application of the teachings of the present invention to a specific problem or environment, and the inclusion of variations of the present invention or additional features thereto (such as further aspects and embodiments), will be within the capabilities of one having ordinary skill in the art in light of the teachings contained herein.

Unless context dictates otherwise, the descriptions and definitions of the features set out above are not limited to any particular aspect or embodiment of the invention and apply equally to all aspects and embodiments which are described.

All references, patents, and publications cited herein are hereby incorporated by reference in their entirety.

### BRIEF DESCRIPTION OF THE FIGURES

The figures show:

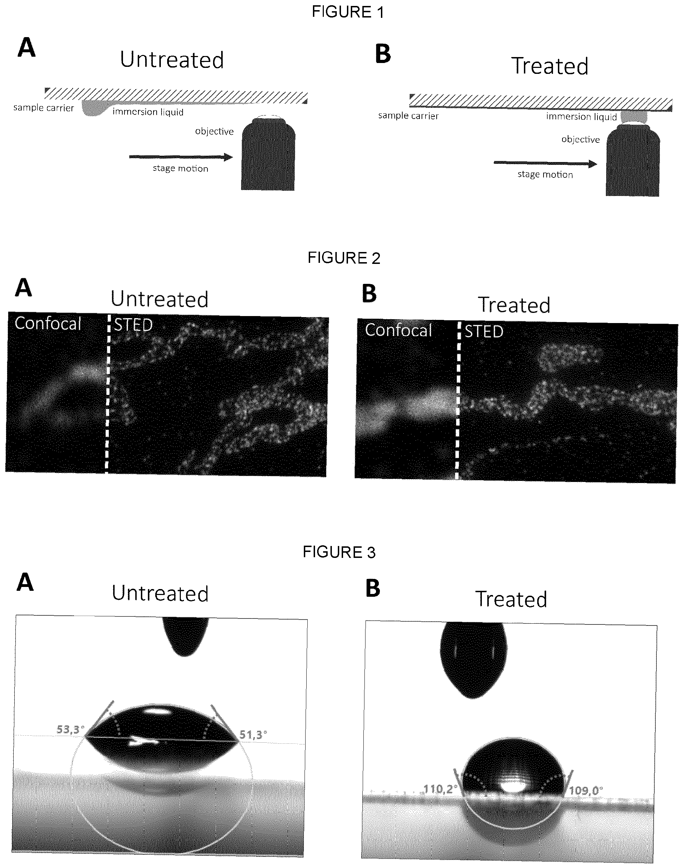

**Figure 1****:** shows a schematic representation of an immersion objective. Left side: An immersion microscopy system without a low surface energy coating is shown. The immersion medium sticks to the coverslip resulting in an eventual loss of contact between immersion objective and coverslip. Right side: A coverslip that comprises a low energy coating of the invention is sued. Due to the coating on the glass coverslip, the immersion medium stays associated with the objective that scans the surface of the coverslip. No immersion medium is lost.
**Figure 2****:** shows STED images of U2OS cells stained with Mic60 antibodies. (A) a coverslip without coating was used. (B) a coverslip with a coating of the invention was used. Both samples in (A) and (B) have been treated identically, were prepared simultaneously and measured on the same day using the same microscopy settings. Both images micrographs are of identical quality.
**Figure 3****:** shows contact angle measurements of a drop of immersion oil on coverslips. (A) shows a coverslip without coating. (B) shows a coverslip with the coating of the invention. Both samples in (A) and (B) were prepared and treated under identical conditions, measured on the same day, and imaged using the same microscopy settings. Both micrographs are of equal quality.

### EXAM PLES

Certain aspects and embodiments of the invention will now be illustrated by way of example and with reference to the description, figures and tables set out herein. Such examples of the methods, uses and other aspects of the present invention are representative only, and should not be taken to limit the scope of the present invention to only such representative examples.

The examples show:

### Example 1: Manufacturing of sample carriers with low surface energy coating

In the following, a protocol that has been used by the inventors to manufacture a glass coverslip with a low-surface energy coating is provided. This protocol can be used for manufacturing a variety of low-surface energy coated articles, such as low-surface energy coated multiwell plates.

To manufacture a coverslip with a low-energy surface coating, the inventors first activated the surface of a glass coverslip. For this, they first cleaned the surface of the coverslip using 100% Isopropanol. Then the surface of the was activated using a BD-20AC LABORATORY CORONA TREATER (Electro-Technic Products, 4642 N. Ravenswood, Chicago, Illinois, USA) by moving over the surface of the coverslip in a continues motion with about 5mm distance for 10 sec.

Next, the activated coverslip was placed in a desiccator with the activated side facing up. The opposite side of the coverslip was covered with parafilm. In the case of manufacturing a multiwell plate with a low surface energy coating, the inventors placed the multiwell plate with the activated side facing up and the non-activated side (featuring wells) facing down, with a lid covering the non-activated side.

Trichloro-(1H,1H,2H,2H-perfluoroctyl)-silane was pipetted into a small dish inside the desiccator and subsequently a negative pressure was generated in the desiccator using a vacuum ejector. Therefore, in this step, the activated coverslips in the desiccator are coated with Trichloro-(1H,1H,2H,2H-perfluoroctyl)-silane from gas phase for 10 minutes.

Afterwards, the resulting coated coverslips were removed from the desiccator.

This resulted in a fluorocarbon-coating on the surface of the coverslip that comprises only a few nanometers thickness. The product results in a self-assembling monolayer (SAM).

### Example 2: Performing STED and Confocal Microscopy Imaging with a coverslip that comprises a low surface energy coating shows no loss of image quality

The inventors tested whether their low surface energy coatings were compatible with highly sensitive light microscopy techniques.

For super-resolution imaging, an Abberior Instruments FACILITY LINE easy3D STED and confocal microscope were employed, equipped with an Olympus IX83 inverted microscope body and a high numerical aperture Olympus UPLXAPO60XO oil-immersion objective (60x, NA 1.42). Sample positioning and imaging were facilitated by a Märzhäuser SCAN IM 120 × 80 motorized stage. Laser excitation was achieved using two distinct wavelengths: 640 nm and 594 nm, selected to match the absorption spectra of the fluorophores used. Fluorescence emission was detected by a laser scanning module equipped with a Rainbow Spectral Detection Kit for efficient spectral separation and maximized signal detection. The STED laser, operating at 775 nm, was employed to deplete the excited state of the fluorophores, achieving lateral resolution enhancement beyond the diffraction limit.

For this, they conducted STED and confocal microscopy on U2Os cells (Figure 2) using a coverslip that was coated with a low surface energy coating according to Example 1 (Figure 2, right) or a coverslip that was not coated with a low-surface energy coating (Figure 2, left). The objective was in contact with said coverslips by a bridging immersion medium. In both cases the cells were stained using antibodies for Mic60 and aATPsynB.

The coatings of the inventors did not influence the refractive index of the coated coverslips nor result in any other effects that would change the aberration of the optical path and potentially negatively influence the highly sensitive STED microscopy. Their low-energy surface coatings were compatible even with highly sensitive, high resolution STED microscopy and did not show any impairment in image quality, background or image resolution.

### Example 3: Comparative Analysis of Wettability and Surface Energy of Coated and Uncoated Coverslips Using Contact Angle Measurements

Contact angle measurements were performed using a Krüss Advance 1.19.0.14201 goniometer to evaluate the wettability of uncoated and a coverslip that was coated with a low surface energy coating according to Example 1. The measurements were conducted under ambient conditions, using water and immersion oil as test liquids. Static contact angles were recorded by depositing a droplet of each liquid onto the surface and capturing the droplet profile. The contact angles were automatically determined using the instrument's integrated software, and representative data are shown in Figure 3.

For surface energy determination of the coated coverslips, the QWRK model was applied. This method involved measuring the contact angles using two probe liquids: water and 1,2-dichloroethane. The surface energy components, including polar and dispersive contributions, were calculated using the obtained contact angle data. This approach allowed for a comprehensive analysis of the surface properties of the coated samples.

## Claims

1. A use of a sample carrier in immersion microscopy, spectroscopy or lithography, wherein the sample carrier comprises a substrate with a first surface that comprises a low surface energy coating as a top layer,
and a second surface that does not comprise the low surface energy coating as a top layer,
wherein, the low surface energy coating of the first surface is in contact with an immersion fluid and the second surface faces a sample, and
wherein the low surface energy coating in contact with the immersion fluid while imaging the sample during the immersion microscopy, measuring electromagnetic spectra of the sample during the spectroscopy, or manipulating the sample during the lithography.

2. The use of claim 1, wherein the sample carrier comprises an optically transparent substrate that comprises the low surface energy coating, preferably wherein the substrate comprises an inorganic glass or crystal (such as quartz), an organic polymer, an organosilicon polymer and/or a metal.

3. The use of claim 1 or 2, wherein the thin film is a monolayer and/or is bound to the surface via chemisorption and/or physisorption, and/or wherein the low surface energy coating is a thin film with a thickness of less than 30 nm, preferably wherein the thin film comprises a thickness of less than 20 nm, less than 15 nm, less than 10 nm, less than 5 nm, preferably as determined by spectroscopic ellipsometry.

4. The use of any one of claims 1 to 3, wherein the sample carrier is a culture plate, a microwell plate, a microscope slide, a microfluidic chip, a cover slip, a channelled slide and/or a culture dish.

5. The use of the sample carrier of any one of claims 1 to 4, wherein the low surface energy coating is a hydrophobic and/or oleophobic coating, preferably wherein the low surface energy coating has a surface energy of less than 70 mN/m, preferably less than 30 mN/m, more preferably less than 20 mN/m preferably less than 10 mN/m.

6. The use of the sample carrier of any one of claims 1 to 5, wherein the low surface energy coating comprises an organic compound, preferably wherein the organic compound is an organosilicon and/or wherein the organic compound is a fluorinated organic compound, more preferably wherein the low surface energy coating comprises a fluorinated siloxane, fluorinated silane, fluorinated organic compound and/or polymers thereof, most preferably wherein the organic compound is Trichloro-(1H,1H,2H,2H-perfluoroctyl)-silane, 1H, 1H, 2H, 2H-perfluorooctyltriethoxysilane or polytetrafluoroethylene..

7. The use of the sample carrier of any one of claims 1 to 6, wherein the first surface does not comprise an additional microstructuring of the substrate and/or wherein the low surface energy coating does not essentially change the microstructuring of the substrate.

8. **A use of a lid in immersion microscopy,** wherein the lid comprises an optically transparent substrate with a first surface that comprises a low surface energy coating as a top layer and a second surface that does not comprise the low surface energy coating as a top layer,
the first surface and the second surface are on opposite sides of the substrate facing away from each other, and
wherein the first surface is in contact with an immersion fluid, and the second surface faces the sample,
wherein the low surface energy coating in contact with an immersion fluid while imaging the sample during the immersion microscopy.

9. **Use a surface** on a substrate in immersion microscopy, spectroscopy or lithography that comprises a low surface energy coating as a top layer, wherein the low surface energy coating comprises a fluorinated organic compound, wherein the low surface energy coating in contact with an immersion fluid while imaging the sample during the immersion microscopy, measuring electromagnetic spectra of the sample during the spectroscopy, or manipulating the sample during the lithography, optionally wherein the surface does not comprise an additional microstructuring of the substrate and/or wherein the low surface energy coating essentially does not change the microstructuring of the substrate.

10. **A sample carrier for immersion** microscopy, spectroscopy or lithography, wherein the sample carrier comprises a substrate with a first surface that comprises a fluorinated low surface energy coating as a top layer, wherein the first surface does not comprise an additional microstructuring of the substrate and/or wherein the microstructuring of the substrate is not essentially changed by the low energy surface coating, preferably wherein the sample carrier is for immersion microscopy and the sample carrier comprises an optically transparent substrate.

11. **A lid for immersion microscopy,** wherein the lid comprises an optically transparent substrate with a first surface that comprises a fluorinated low surface energy coating as a top layer, wherein the first surface does not comprise an additional microstructuring of the substrate and/or wherein the microstructuring of the substrate is not essentially changed by the low energy surface coating.

12. **A kit** for immersion microscopy, spectroscopy or lithography, containing an immersion fluid and a sample carrier and/or a lid according to any one of claims 1 to 8 or 10 or 11, preferably, wherein the immersion fluid, when measured in a sessile drop measurement using a contact angle goniometer, comprises a contact angle of >90°, >100°, > 120°, > 150° on the first surface.

13. The kit according to claim 12, wherein the immersion fluid is an immersion oil, preferably a mineral immersion oil, silicone immersion oil and/or halogenated immersion oil, the immersion oil has a kinematic viscosity of that is lower than 1500 mm² s⁻¹ at 37 °C, more preferably lower than 1000 mm² s⁻¹ at 37 °C, more preferably lower than 700 mm²·s⁻¹ at 37 °C, most preferably lower than at least 500 mm²·s⁻¹ at 37 °C, when measured in a Ostwald viscometer at 37 °C.

14. A method for preparing a surface of an optically transparent substrate for immersion microscopy, spectroscopy or lithography according to claim 10 or 11, the method comprising
(i) Providing a surface on an optically transparent substrate;
(ii) Applying a low surface energy coating as a top layer to the surface on the substrate;
thus obtaining a substrate with a surface that comprises the low surface energy coating as a top layer.

15. A method for immersion microscopy, spectroscopy or lithography, the method comprising the steps of:
(a) preparing a first surface of a sample carrier, or lid according to the method of claim 14,
(b) Using the resulting sample carrier, lid or cover slip in immersion microscopy, spectroscopy or lithography according to any one of claims 1 to 8.
